# DEMANDE DE BREVET EUROPEEN

(11) **EP 2 463 491 A1**
(43) Date de publication de la demande: **13.06.2012**
(21) Numéro de dépôt: 11290498.2
(22) Date de dépôt: 27.10.2011
(51) Int. Cl.: F01N 5/02, F01N 3/20

(54) **Procédé et dispositif de contrôle de la température des gaz d'échappement d'un moteur à combustion interne traversant un moyen de traitement des polluants contenus gans ces gaz**

(30) Priorité: 08.12.2010 FR 1004783
(71) Demandeur: IFP Energies Nouvelles, 92852 Rueil Malmaison Cedex (FR)
(72) Inventeur: Mendez, Sylvain, 44230 Saint-Etienne (FR); Ternel, Cyprien, 78210 Saint Cyr l'Ecole (FR)

(57) **Abrégé**

La présente invention concerne un procédé de contrôle de la température des gaz d'échappement circulant dans une ligne d'échappement (20) d'un moteur à combustion interne (10), ladite ligne comportant des moyens de traitement des polluants (30) contenus dans ces gaz et des moyens d'échange de chaleur (32) pour refroidir ou chauffer lesdits gaz d'échappement traversant ces moyens de traitement des polluants.
Selon l'invention, le procédé consiste à utiliser l'évaporateur (38) d'un circuit fermé de circulation de fluide (34) en tant que moyens d'échange de chaleur (32).

## Description

La présente invention se rapporte à un procédé et à un dispositif de contrôle de la température des gaz d'échappement d'un moteur à combustion interne, notamment de type Diesel, qui traversent un moyen de traitement des polluants contenus dans ces gaz.

Afin de respecter les normes environnementales et de répondre à la sévèrisation de ces normes, telles que les normes dites EURO VI, il est nécessaire de traiter les polluants, en particulier, les oxydes d'azote (NO et NO₂), plus communément baptisés NOx, que contiennent ces gaz d'échappement avant de les rejeter dans l'atmosphère.

Pour cela et comme cela est généralement connu, des dispositifs de traitement de ces polluants sont mis en place sur la ligne d'échappement des véhicules.

Cette ligne d'échappement comprend, à partir du collecteur d'échappement et dans le sens de circulation des gaz d'échappement le long de la ligne, un catalyseur trois voies, dit catalyseur triple effet, qui a pour fonction de traiter, par oxydation, les hydrocarbures imbrûlés (HC) et le monoxyde de carbone (CO) contenus dans les gaz d'échappement, et un catalyseur RCS (Réduction Catalytique Sélective) pour le traitement des NOx.

Ce catalyseur RCS permet de réduire sélectivement les NOx en azote grâce à l'action d'un agent réducteur. Cet agent, qui est généralement injecté en amont du catalyseur peut être un hydrocarbure, de l'hydrogène, du monoxyde de carbone, de l'ammoniac ou un composé générant de l'ammoniac par décomposition, comme de l'urée.

Le problème posé avec un tel dispositif réside dans le fait que le catalyseur RCS est opérationnel avec une température comprise dans une fenêtre d'environ 300°C à environ 500°C.

Or, il n'est pas toujours possible de contrôler finement la température des gaz d'échappement, car elle dépend fortement du point de fonctionnement du moteur. Ainsi, pour les fortes charges du moteur notamment, la température des gaz d'échappement peut dépasser largement la température de 500°C. Cette température élevée, d'une part, ne permet pas au catalyseur de remplir sa fonction de réduction des NOx et, d'autre part, peut entraîner une dégradation du matériau constitutif de ce catalyseur et/ou des phases catalytiques qu'il comporte.

Il est déjà connu de disposer des moyens d'échange de chaleur sur la ligne d'échappement et en amont du catalyseur RCS pour refroidir les gaz d'échappement avant qu'ils ne pénètrent dans ce catalyseur.

Pour cela, un refroidisseur, qui est parcouru par le fluide de refroidissement du moteur, est placé sur la ligne d'échappement. Ce refroidisseur permet d'absorber la chaleur contenue dans les gaz d'échappement et ainsi de contrôler la température de ces gaz de manière à ce qu'elle ne dépasse pas la valeur haute de la fenêtre de température de fonctionnement de ce catalyseur.

Ceci a cependant pour inconvénient notable de générer une augmentation de la température du fluide de refroidissement qui est réchauffé par les gaz d'échappement. Comme ce fluide est également utilisé pour refroidir le moteur et d'autres accessoires de ce moteur au travers d'un radiateur de refroidissement, il est donc nécessaire d'augmenter la capacité de ce radiateur. En cas de limitation de l'encombrement pour le radiateur de refroidissement, il est nécessaire de prévoir des radiateurs de refroidissement additionnels pour amener ce fluide de refroidissement à une température requise. Cela entraîne une augmentation de coût non négligeable ainsi qu'une complexité dans le circuit général de refroidissement du moteur.

De plus, lorsque la température de ces gaz est inférieure à celle requise pour assurer le fonctionnement du catalyseur, notamment au démarrage du moteur ou après un arrêt de ce moteur, les gaz d'échappement contenant des NOx ne sont pas traités par le catalyseur et sont rejetés dans l'atmosphère avec leurs polluants.

La présente invention vise à remédier aux inconvénients mentionnés ci-dessus grâce à un dispositif simple et économique qui permette de disposer de gaz d'échappement avec la température requise pour assurer le traitement en dépollution de ces gaz et cela quelque soit les conditions de fonctionnement du moteur à combustion interne.

A cet effet, la présente invention concerne un procédé de la température des gaz d'échappement circulant dans une ligne d'échappement d'un moteur à combustion interne, ladite ligne comportant des moyens de traitement des polluants contenus dans ces gaz et des moyens d'échange de chaleur pour refroidir ou chauffer lesdits gaz d'échappement traversant ces moyens de traitement des polluants.

Le procédé peut consister à introduire un fluide chaud dans l'évaporateur pour qu'il chauffe les gaz d'échappement.

Le procédé peut consister à utiliser un fluide chaud contenu dans un moyen de stockage de fluide relié au circuit.

Le procédé peut consister à relier le moyen de stockage à l'évaporateur par une conduite de dérivation.

L'invention concerne également un dispositif de contrôle de la température des gaz d'échappement circulant dans une ligne d'échappement d'un moteur à combustion interne, ladite ligne comportant des moyens de traitement des polluants contenus dans ces gaz et des moyens réversibles d'échange de chaleur pour refroidir ou chauffer lesdits gaz d'échappement traversant ces moyens de traitement des polluants, caractérisé en ce que les moyens réversibles d'échange réversible sont un évaporateur d'un circuit fermé de circulation de fluide.

Le circuit peut comprendre un réservoir de stockage d'un fluide.

Le réservoir peut être un réservoir thermocalorifugé.

Le réservoir peut comprendre des moyens de chauffage du fluide.

Le circuit peut comprendre une conduite de dérivation pour admettre le fluide du réservoir vers l'évaporateur.

La conduite de dérivation peut porter un moyen de vannage.

Les moyens d'échange de chaleur réversibles peuvent comprendre au moins une thermopile.

La thermopile peut être reliée à des accumulateurs électriques pour l'alimenter électriquement lors du chauffage des gaz d'échappement.

Les moyens de traitement des polluants peuvent comprendre un catalyseur à réduction catalytique sélective.

Les autres caractéristiques et avantages de l'invention vont apparaître maintenant à la lecture de la description qui va suivre, donnée à titre uniquement illustratif et non limitatif, et à laquelle sont annexées :
- la figure 1 qui est un schéma montrant un dispositif de contrôle de la température des gaz d'échappement d'un moteur à combustion interne selon l'invention,
- la figure 2 qui est une vue plus détaillée d'une partie du dispositif de la figure 1 et
- la figure 3 qui est un autre schéma illustrant une variante du dispositif tel que montré à la figure 1.

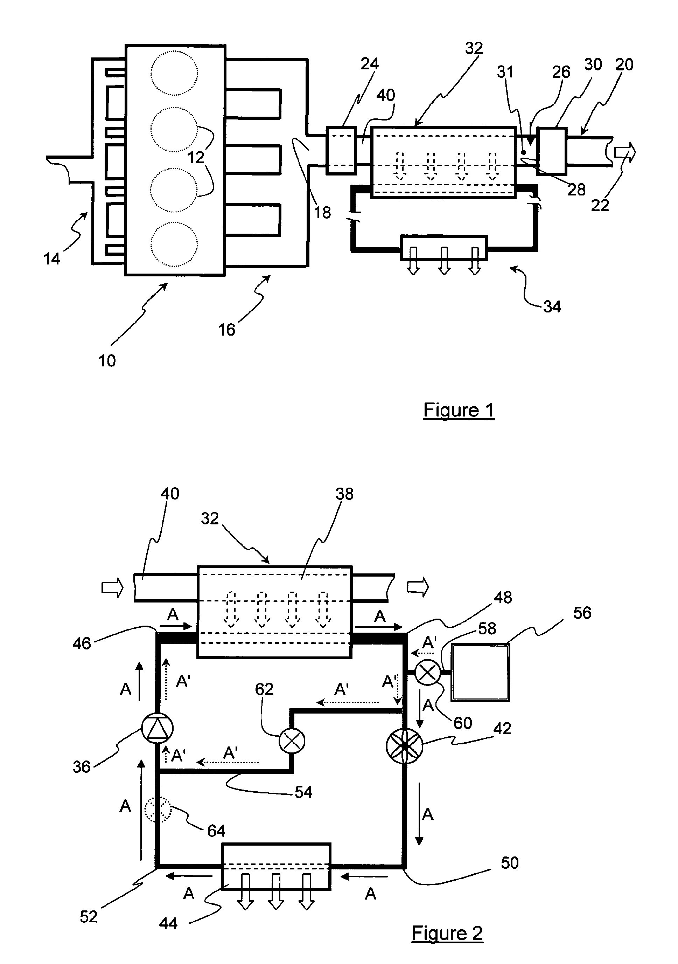

En se rapportant à la figure 1, le moteur à combustion interne 10, notamment de type Diesel, comporte au moins un cylindre 12, un répartiteur d'admission 14 et un collecteur d'échappement 16 permettant de collecter les gaz d'échappement résultant de la combustion d'un mélange carburé dans les cylindres pour les diriger vers l'entrée 18 d'une ligne d'échappement 20.

Sur la figure 1, la ligne d'échappement porte, dans le sens de circulation des gaz d'échappement allant de l'entrée 18 de cette ligne vers sa sortie (symbolisée par la flèche 22), un catalyseur d'oxydation trois voies 24, placé au plus près de l'entrée 18 de gaz d'échappement, suivi d'un injecteur d'un agent réducteur 26, ici de l'urée, placé en regard de la face d'entrée 28 d'un catalyseur RCS 30. Cette ligne porte également un capteur de température 31 des gaz d'échappement qui est logé en vis-à-vis et à proximité de la face d'entrée 28 du catalyseur RCS. Ce capteur permet, en association avec le calculateur que comporte habituellement tout moteur à combustion interne, de connaître la température des gaz d'échappement qui pénètrent dans ce catalyseur.

Comme mieux visible sur la figure 1, un échangeur de chaleur réversible 32 est prévu entre les deux catalyseurs pour contrôler la température des gaz d'échappement aboutissant sur la face d'entrée 28 du catalyseur RCS. De manière avantageuse, cet échangeur et placé en aval du catalyseur trois voies et en amont du capteur de température.

Cet échangeur permet de refroidir ces gaz ou de les chauffer de manière à ce que leur température soit située dans la fenêtre habituelle de fonctionnement du catalyseur RCS qui est généralement comprise entre environ 300°C et environ 500°C.

Plus précisément et en se rapportant à la figure 2, cet échangeur fait partie d'un circuit fermé de circulation de fluide 34 et plus particulièrement du type à cycle de Rankine.

Ce circuit comprend un moyen de circulation et de compression 36 d'un fluide de travail, ici de l'eau, circulant dans ce circuit selon un sens horaire (Flèches A). Ce moyen, dénommé compresseur, permet de comprimer cette eau et est avantageusement entraîné en rotation par tous moyens connus, comme par un moteur électrique (non représenté).

Ce circuit comporte, à la suite du compresseur, un moyen d'échange de chaleur 38, ici un évaporateur, traversé par l'eau comprimée d'où elle ressort sous forme de vapeur comprimée.

Cet évaporateur est placé sur la portion 40 de la ligne d'échappement 20 compris entre les deux catalyseurs 24 et 30, de préférence en amont de l'injecteur 26 et du capteur 31, de manière à pouvoir refroidir les gaz d'échappement circulant dans cette portion ou de les chauffer.

Il est à la portée de l'homme de métier d'envisager toutes les configurations possibles pour disposer cet évaporateur en liaison directe ou indirecte avec cette portion de ligne d'échappement de manière à assurer le meilleur échange de chaleur avec les gaz d'échappement.

Faisant suite à cet évaporateur, le circuit comporte également un détendeur 42 recevant de cet évaporateur la vapeur d'eau comprimée à haute pression et la faisant ressortir sous forme de vapeur détendue à basse pression.

Ce détendeur peut être à titre d'exemple une turbine de détente dont le rotor est entraîné en rotation par la vapeur d'eau. Ce rotor est avantageusement relié à un dispositif pour transformer l'énergie mécanique récupérée en une autre énergie, comme par exemple une génératrice électrique.

Le circuit comporte également un échangeur de refroidissement 44 ou condenseur, recevant la vapeur basse pression détendue provenant du détendeur pour obtenir en sortie de ce condenseur de la vapeur transformée en eau sous forme liquide. Ce condenseur est, dans l'exemple de la figure 1, balayé par un fluide de refroidissement qui est avantageusement de l'air extérieur à température ambiante.

Des conduites de circulation de fluide permettent de relier successivement les différents éléments de ce circuit pour que le fluide de travail, sous forme liquide ou sous forme vapeur, circule selon le sens indiqué par les flèches. Plus précisément, ce circuit comprend une conduite 46 entre le compresseur à l'évaporateur, une conduite 48 entre l'évaporateur et le détendeur, une conduite 50 entre le détendeur et le condenseur et une conduite 52 entre le condenseur et le compresseur.

En outre, ce circuit comprend une conduite de dérivation 54 qui prend naissance sur la conduite 48 entre l'évaporateur et le détendeur et qui aboutit sur la conduite 52 entre le condenseur et le compresseur. De plus, un réservoir avantageusement thermocalorifugé 56 est raccordé à la conduite 48 par une conduite de raccordement 58 qui aboutit sur la portion de la conduite 48 comprise entre l'évaporateur et le point de départ de la conduite de dérivation 54. Cette conduite de dérivation ainsi que la conduite de raccordement 58 portent chacune un moyen de vannage permettant de contrôler la circulation de fluide dans ces conduites, comme une vanne respectivement 60 et 62.

Le réservoir 56 associé aux conduites 54 et 58 ainsi qu'aux vannes 60 et 62 permettent d'assurer la réversibilité de l'échange de chaleur de l'évaporateur pour transformer cet évaporateur de sa fonction de refroidisseur en une fonction de générateur de chaleur pour chauffer les gaz d'échappement circulant dans la portion 40.

Lors du fonctionnement du moteur, le calculateur (associé au capteur 31) peut évaluer que la température des gaz d'échappement est, soit excessive (supérieur à environ 500°C), soit insuffisante (inférieure à environ 300°C) pour assurer le bon fonctionnement du catalyseur RCS 30.

Dans le cas où cette température est excessive, le circuit 34 est mis en fonctionnement de manière à refroidir les gaz d'échappement qui circulent dans la portion 40 de la ligne 20 en assurant un échange de chaleur entre les gaz circulant dans cette portion et l'évaporateur 38.

Plus précisément, les vannes 60, 62 sont dans une position de fermeture des conduites 54, 58 et l'eau circule dans ce circuit selon un sens horaire conventionnel en considérant la figure (flèches A) sous l'effet du compresseur 36. L'eau comprimée, qui sort de ce compresseur, circule dans la conduite 46 pour aboutir à l'évaporateur 38. Cette eau comprimée traverse ensuite l'évaporateur en captant la chaleur que véhiculent les gaz d'échappement et qui est transmise à cet évaporateur. Sous l'effet de cette chaleur captée à partir des gaz, la température de ces derniers est abaissée et l'eau est chauffé pour sortir de cet évaporateur sous forme de vapeur comprimée chaude. La vapeur d'eau traverse ensuite le détendeur 42 en lui transmettant l'énergie qu'elle contient. La vapeur d'eau détendue, qui sort de ce détendeur par la conduite 50, traverse le condenseur 44 d'où elle ressort sous forme d'eau liquide. Cette eau liquide est enfin amenée par la conduite 52 au compresseur 36 pour y être comprimée.

Le circuit 10 est ainsi laissé en fonctionnement jusqu'à ce que la température des gaz d'échappement qui arrivent sur la face d'entrée du catalyseur RCS soit celle requise pour le fonctionnement de ce catalyseur.

Juste avant l'arrêt du fonctionnement du circuit, la vanne 60 de la conduite de raccordement 58 est placée dans une position ouverte de manière à ce que la vapeur d'eau qui sort de l'évaporateur 38 soit introduite dans le réservoir de stockage thermocalorifugé 56 dans lequel elle sera conservée à température élevée.

Cette vanne est ensuite placée dans une position de fermeture dés que le réservoir est rempli par cette vapeur.

A l'inverse, dans le cas d'une température insuffisante des gaz d'échappement pour assurer le bon fonctionnement du catalyseur RCS 30, notamment au démarrage du moteur, les vannes 60 et 62 sont placées dans un position d'ouverture des conduites 58, 54 et le compresseur 36 est mis en fonctionnement.

Dans cette configuration, la vapeur d'eau à température élevée contenue dans le réservoir 56 est évacuée de ce dernier au travers de la conduite de raccordement 58 pour aboutir dans la conduite 48. Sous l'effet du compresseur 36, cette vapeur d'eau circule selon un sens horaire en considérant les flèches A' de la figure 1.

La vapeur circule ainsi dans une portion de la conduite 48 puis dans la conduite de dérivation 54 pour aboutir à l'entrée du compresseur. Cette vapeur d'eau sort de ce compresseur pour aboutir dans l'évaporateur 38. Par cela, cet évaporateur inverse sa fonction initiale de captage de chaleur contenue dans les gaz. Plus précisément, l'évaporateur se transforme en un générateur de chaleur en cédant la chaleur contenue dans la vapeur aux gaz d'échappement circulant dans la portion 40 de la ligne d'échappement. Ceci permet de réaliser le chauffage de ces gaz par échange thermique. Par cela, il est possible d'augmenter rapidement la température des gaz et de réduire fortement le délai pour obtenir la température adéquate des gaz d'échappement pour le fonctionnement du catalyseur RCS.

Avantageusement, il peut être prévu de placer une vanne additionnelle 64 (en trait pointillé sur la figure 1) sur la conduite 50 ou 52 de façon à ce que, en position fermée pour ces conduites, la vapeur ne puisse pas traverser le condenseur 44.

Bien entendu, cette vanne additionnelle est placée dans une position ouverte des conduites 50 ou 52 dans la configuration où ce circuit est utilisé pour assurer le refroidissement des gaz d'échappement.

Ainsi, par des dispositions simples de ce circuit fermé, il est possible soit de refroidir les gaz d'échappement, soit, de manière réversible, de les chauffer par le même évaporateur.

Bien entendu et cela sans sortir du cadre de l'invention il peut être prévu d'utiliser en lieu et place du réservoir thermocalorifugé, un réservoir muni de moyens de chauffage de liquide qu'il contient, comme des résistances électriques de chauffage, un brûleur, ...

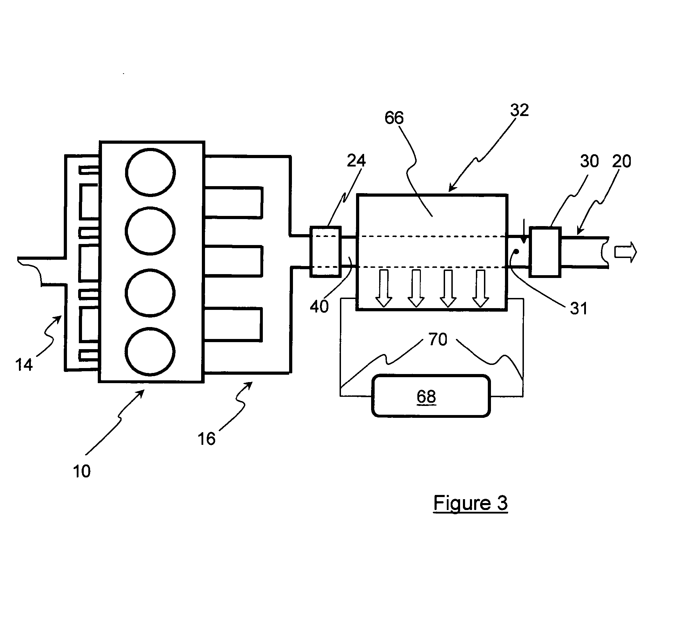

On se rapporte maintenant à la figure 3 qui montre une variante du dispositif à échange de chaleur réversible 32 prévu entre les deux catalyseurs 24, 30 pour contrôler la température des gaz d'échappement aboutissant sur la face d'entrée 28 du catalyseur RCS 30.

Ce dispositif comprend une thermopile ou une succession de thermopiles 66 placées sur la portion 40 de la ligne d'échappement 20 entre le catalyseur trois voies 24 et le catalyseur RCS 30.

Généralement, cette thermopile permet de récupérer l'énergie calorifique contenue dans les gaz d'échappement et de la transformer, notamment par effet Seebeck, en une énergie électrique qui est ensuite stockée dans des accumulateurs électriques 68 au travers de conducteurs 70.

Bien entendu, comme pour la figure 1, l'homme de métier peut envisager toutes les configurations possibles pour disposer cette thermopile en liaison directe ou indirecte avec cette portion de ligne d'échappement de manière à assurer le meilleur échange de chaleur avec les gaz d'échappement.

Ainsi, dans le cas où la température des gaz d'échappement est excessive (supérieur à environ 500°C), la thermopile est active pour assurer un échange de chaleur entre les gaz circulant dans la portion 40 de la ligne 20 et cette thermopile en captant la chaleur que contiennent ces gaz. Par cela, les gaz d'échappement sont refroidis et la thermopile collecte l'énergie calorifique contenue dans le flux de gaz d'échappement pour la transformer en énergie électrique qui est stockée dans des accumulateurs 68.

Une fois que la température des gaz d'échappement est stabilisée, le fonctionnement de la thermopile peut être interrompu.

Dans la situation inverse où la température des gaz d'échappement est en dessous de son seuil minimum pour assurer le fonctionnement du catalyseur RCS 30, la thermopile 66 est alimentée électriquement par les accumulateurs 68.

Cette alimentation électrique a pour effet de chauffer la thermopile qui peut alors transférer sa chaleur aux gaz d'échappement circulant dans la portion 40 de la ligne 20.

De même, une fois que la température des gaz d'échappement a atteint la valeur recherchée, l'alimentation de la thermopile est stoppée de manière à arrêter le chauffage des gaz d'échappement qui est devenu inutile.

Grâce à la réversibilité de l'échange de chaleur de la thermopile, les gaz d'échappement peuvent être refroidis ou chauffés de manière à ce que leur température soit située dans la fenêtre habituelle de fonctionnement du catalyseur RCS.

## Revendications

1. Procédé de contrôle de la température des gaz d'échappement circulant dans une ligne d'échappement (20) d'un moteur à combustion interne (10), ladite ligne comportant des moyens de traitement des polluants (30) contenus dans ces gaz et des moyens d'échange de chaleur (32) pour refroidir ou chauffer lesdits gaz d'échappement traversant ces moyens de traitement des polluants, **caractérisé en ce qu'**il consiste à utiliser l'évaporateur (38) d'un circuit fermé de circulation de fluide (34) en tant que moyens d'échange de chaleur (32).

2. Procédé selon la revendication 1, **caractérisé en ce qu'**il consiste à introduire un fluide chaud dans l'évaporateur pour qu'il chauffe les gaz d'échappement.

3. Procédé selon la revendication 2, **caractérisé en ce qu'**il consiste à utiliser un fluide chaud contenu dans un moyen de stockage de fluide (56) relié au circuit.

4. Procédé selon l'une des revendications précédentes, **caractérisé en ce qu'**il consiste à relier le moyen de stockage (56) à l'évaporateur (38) par une conduite de dérivation (54).

5. Dispositif de contrôle de la température des gaz d'échappement circulant dans une ligne d'échappement (20) d'un moteur à combustion interne (10), ladite ligne comportant des moyens de traitement des polluants (30) contenus dans ces gaz et des moyens réversibles d'échange de chaleur (32) pour refroidir ou chauffer lesdits gaz d'échappement traversant ces moyens de traitement des polluants, **caractérisé en ce que** les moyens réversibles d'échange réversible sont un évaporateur (38) d'un circuit fermé de circulation de fluide (34).

6. Dispositif selon la revendication 5, **caractérisé en ce que** le circuit (34) comprend un réservoir de stockage (56) d'un fluide chaud.

7. Dispositif selon la revendication 6, **caractérisé en ce que** le réservoir est un réservoir thermocalorifugé.

8. Dispositif selon la revendication 6 ou 7, **caractérisé en ce que** le réservoir comprend des moyens de chauffage du fluide.

9. Dispositif selon l'une des revendications 5 à 8, **caractérisé en ce que** le circuit (34) comprend une conduite de dérivation (54) pour admettre le fluide du réservoir dans l'évaporateur (38).

10. Dispositif selon la revendication 9, **caractérisé en ce que** la conduite de dérivation (54) porte un moyen de vannage (62).

11. Dispositif selon la revendication 5, **caractérisé en ce que** les moyens de traitement des polluants comprennent un catalyseur à réduction catalytique sélective (30).
